# EUROPEAN PATENT APPLICATION

(11) **EP 4 546 629 A1**
(43) Date of publication of application: **30.04.2025**
(21) Application number: 23306869.1
(22) Date of filing: 27.10.2023
(51) Int. Cl.: H02M 1/32, H02M 7/5387, H02M 1/02

(54) **ACTIVE-DISCHARGE CONTROL IN FAIL SAFE STATE**

(71) Applicant: NXP B.V., 5656 AG Eindhoven (NL)
(72) Inventor: Santiago, Erik, 31023 Toulouse (FR); Calmes, Pierre Philippe, 31023 Toulouse (FR); Clairet, Maxime, 31023 Toulouse (FR); Culie, Olivier, 31023 Toulouse (FR); Bourlot, Xavier, 31023 Toulouse (FR); Dubois, Antoine Fabien, 31023 Toulouse (FR)
(74) Representative: Krott, Michel

(57) **Abstract**

An inverter circuit, including: a first phase circuit including: a first transistor; a first gate driver configured to control the first transistor; a second transistor connected in series with the first transistor; and a second gate driver configured to control the second transistor; a microcontroller unit (MCU) configured to produce a first control signal and a second control signal to control an operation of the first gate driver and the second gate driver, respectively; and a power management circuit configured to: detect a failure in an operation of the MCU; and produce a third control signal and a fourth control signal to control the operation of the first gate driver and the second gate driver to control the discharge of the charging capacitor when the failure in the operation of the MCU is detected.

## Description

### FIELD OF THE DISCLOSURE

Various exemplary embodiments disclosed herein relate to active-discharge control in fail safe state for inverters and other systems.

### BACKGROUND

In electric vehicles inverters are used that include a direct current (DC) link including a charging capacitor. When the system is powered off or placed in a safe state, the capacitor needs to be discharged. These systems may be subject to a time requirement for the capacitor to discharge: for example, 2 s.

### SUMMARY

A summary of various exemplary embodiments is presented below.

Various embodiments relate to an inverter circuit, including: a first phase circuit including: a first transistor; a first gate driver configured to control the first transistor; a second transistor connected in series with the first transistor; and a second gate driver configured to control the second transistor; a microcontroller unit (MCU) configured to produce a first control signal and a second control signal to control an operation of the first gate driver and the second gate driver, respectively, wherein the first control signal and second control signal are configured to control a discharge of a charging capacitor connected to the first phase circuit; and a power management circuit configured to: detect a failure in an operation of the MCU; and produce a third control signal and a fourth control signal to control the operation of the first gate driver and the second gate driver to control the discharge of the charging capacitor when the failure in the operation of the MCU is detected.

Various embodiments are described, wherein the power management circuit is configured to send the third control signal to indicate the failure of the MCU to the first gate driver and the second gate driver.

Various embodiments are described, wherein the second gate driver is configured to turn the second transistor on when the third control signal indicates the failure of the MCU.

Various embodiments are described, wherein the power management circuit is configured to send the fourth control signal with an entry pattern indicating a start of the discharge of the charging capacitor to the first gate driver.

Various embodiments are described, wherein the entry pattern is sent after a first delay period of time after the indication of the failure of the MCU.

Various embodiments are described, wherein the first delay period is configurable.

Various embodiments are described, wherein the first gate driver is configured to drive the first transistor with a pulse width modulated signal after the first gate driver receives the fourth control signal with the entry pattern.

Various embodiments are described, wherein the power management circuit is configured to send the fourth control signal after a second delay time with an exit pattern indicating an end of the discharge of the charging capacitor to the first gate driver, wherein the exit pattern is different than the entry pattern.

Various embodiments are described, wherein the entry pattern includes a first number of pulses and the exit pattern includes a second number of pulses.

Various embodiments are described, wherein the second delay time is configurable.

Various embodiments are described, wherein the MCU is configured to override the third control signal and the fourth control signal when asserted by the power management circuit.

Various embodiments are described, further including: a second phase circuit including: a third transistor; a third gate driver configured to control the third transistor; a fourth transistor connected in series with the third transistor; and a fourth gate driver configured to control the fourth transistor; wherein the first control signal and the second control signal are configured to control the operation of the third gate driver and the fourth gate driver, respectively, and wherein the third control signal and the fourth control signal are configured to control the operation of the third gate driver and the fourth gate driver to control the discharge of the charging capacitor when the failure in the operation of the MCU is detected.

Further various embodiments relate to an inverter circuit, including: a first, second, and third phase circuit, wherein each phase circuit includes: a first transistor; a first gate driver configured to control the first transistor; a second transistor connected in series with the first transistor; a second gate driver configured to control the second transistor; a microcontroller unit (MCU) configured to produce a first control signal and a second control signal to control an operation of the first gate drivers and the second gate drivers, respectively, wherein the first control signal and second control signal are configured to control a discharge of a charging capacitor connected to the first phase circuit; and a power management circuit configured to: detect a failure in an operation of the MCU; and produce a third control signal and a fourth control signal to control the operation of the first gate drivers and the second gate drivers to control the discharge of the charging capacitor when the failure in the operation of the MCU is detected.

Various embodiments are described, wherein the power management circuit is configured to send the third control signal to indicate the failure of the MCU to the first gate drivers and the second gate drivers.

Various embodiments are described, wherein the second gate drivers are configured to turn the second transistors on when the third control signal indicates the failure of the MCU.

Various embodiments are described, wherein the power management circuit is configured to send the fourth control signal with an entry pattern indicating a start of the discharge of the charging capacitor to the first gate drivers.

Various embodiments are described, wherein the entry pattern is sent after a first delay period of time after the indication of the failure of the MCU.

Various embodiments are described, wherein the first gate drivers are configured to drive the first transistors with a pulse width modulated signal after the first gate drivers receive the fourth control signal with the entry pattern.

Various embodiments are described, wherein the power management circuit is configured to send the fourth control signal after a second delay time with an exit pattern indicating an end of the discharge of the charging capacitor to the first gate driver, wherein the exit pattern is different than the entry pattern.

Various embodiments are described, wherein the MCU is configured to override the third control signal and the fourth control signal when asserted by the power management circuit.

The foregoing has outlined rather broadly the features and technical advantages of examples according to the disclosure in order that the detailed description that follows may be better understood. Additional features and advantages will be described hereinafter. The conception and specific examples disclosed may be readily utilized as a basis for modifying or designing other structures for carrying out the same purposes of the present disclosure. Such equivalent constructions do not depart from the scope of the appended claims. Characteristics of the concepts disclosed herein, both their organization and method of operation, together with associated advantages will be better understood from the following description when considered in connection with the accompanying figures. Each of the figures is provided for the purposes of illustration and description, and not as a definition of the limits of the claims.

### BRIEF DESCRIPTION OF DRAWINGS

So that the above-recited features of the present disclosure can be understood in detail, a more particular description, briefly summarized above, may be had by reference to aspects, some of which are illustrated in the appended drawings. It is to be noted, however, that the appended drawings illustrate only certain typical aspects of this disclosure and are therefore not to be considered limiting of its scope, for the description may admit to other equally effective aspects. The same reference numbers in different drawings may identify the same or similar elements.
FIG. 1 illustrates an inverter for use with an electric motor.
FIG. 2 illustrates an embodiment of an inverter that accounts for a failure of the MCU.
FIG. 3 illustrates the control signals for entering and exiting the discharge mode.
FIG. 4 illustrates one example of a DC LINK entry pattern.
FIG. 5 illustrates one example of a DC LINK exit pattern.

### DETAILED DESCRIPTION

Various aspects of the disclosure are described more fully hereinafter with reference to the accompanying drawings. This disclosure may, however, be embodied in many different forms and should not be construed as limited to any specific structure or function presented throughout this disclosure. Rather, these aspects are provided so that this disclosure will be thorough and complete and will fully convey the scope of the disclosure to those skilled in the art. Based on the teachings herein one skilled in the art should appreciate that the scope of the disclosure is intended to cover any aspect of the disclosure disclosed herein, whether implemented independently of or combined with any other aspect of the disclosure. For example, an apparatus may be implemented or a method may be practiced using any number of the aspects set forth herein. In addition, the scope of the disclosure is intended to cover such an apparatus or method which is practiced using other structure, functionality, or structure and functionality in addition to or other than the various aspects of the disclosure set forth herein. It should be understood that any aspect of the disclosure disclosed herein may be embodied by one or more elements of a claim.

Several aspects of methods and systems for active-discharge control during a fail-safe state will now be presented with reference to various apparatuses and techniques. These apparatuses and techniques will be described in the following detailed description and illustrated in the accompanying drawings by various blocks, modules, components, circuits, steps, processes, algorithms, and/or the like (collectively referred to as "elements"). These elements may be implemented using hardware, software, or combinations thereof. Whether such elements are implemented as hardware or software depends upon the particular application and design constraints imposed on the overall system.

Electric vehicles (EV) may include an inverter with three phases to drive electric motors. The inverter may include a DC link with a charging capacitor that collects energy and then provides that energy to the electric motor as needed during operation. When the inverter is to be placed in a safe state or powered down, this charging capacitor needs to be discharged to prevent an electrocution hazard. Various regulatory bodies have set regulations that specify a discharge time for this charging capacitor when the system shuts down or enters a safe state. For example, this time may be 2s to avoid electrocution. Today this discharge is realized either by passive components which are costly and big (big resistors and switch controlled by a microcontroller unit (MCU)) or with MCU pulse width modulation (PWM) control of the three legs of the inverter through gate drivers. A problem with those solutions is that if the MCU or the logic controller is in fault, the active DC link discharge cannot be activated, then the system retains the high voltage (HV) potential on the charging capacitor, and it results in a dangerous situation where the charging capacitor continues to hold a charge which prevents entering a safety state for the system.

A discharge control system and method are disclosed herein that uses an existing feature of a gate driver to carry out the discharge even when the MCU is no longer working. The inverter includes a system basis chip (SBC) that is a power management circuit that supplies power to the MCU and the gate drivers. It may include other logic as well. With some smart logic integrated in the SBC and when an MCU fault or failure is detected, the SBC could setup all high side (HS) gate drivers into a discharge mode (where the gate driver may automatically select gate voltage to limit discharge current by acting as a resistor) while all low side (LS) gate drivers are ON. Because this is done on all of the legs of the inverter, each of the legs sees lower current, and it also provides increased fault tolerance. In other embodiments, the LS transistors may be set to act as the resistor and the HS transistor is always on. The SBC can directly control the gate driver to activate the DC link discharge mode after a delay if needed.

When the SBC detects the microcontroller fault, the SBC will then start to force an active short circuit during a preprogrammed duration to discharge motor energy and then automatically send a dedicated pattern signal to the gate drivers in order to enter into a discharge mode. To be safe when the battery contactors are still closed, the SBC may also have a preprogrammed maximum duration to exit DC link discharge and will send an exit pattern to the gate drivers to make sure discharge is terminated.

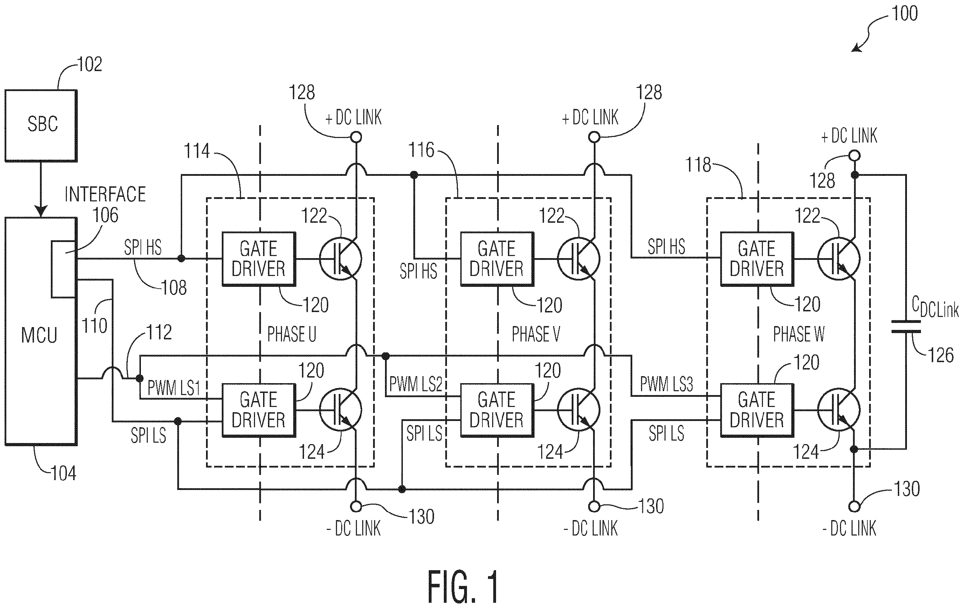

FIG. 1 illustrates an inverter for use with an electric motor. The inverter 100 includes the SBC 102, MCU 104, phase U 114, phase V 116, phase W 118, and charging capacitor 126. The inverter 100 is connected to +DC link 128 and -DC link 130. Each phase of the inverter 100 includes two gate drivers 120, and a HS drive transistor 122, and a LS drive transistor 124. The MCU 104 may include an interface 106 that is connected to each of the gate drivers 120. The MCU 104 produces the control signals including HS control signal 108, LS control signal 110, and PWM control signal 112. The HS control signal 108 and LS control signal 110 are used to turn the HS drive transistors 122 and LS drive transistors 124 on and off, respectively. Further, the PWM control signal 112 may be used to control the on and off time of the LS drive transistors 124. The SBC 102 is a power management integrated circuit that supplies power to the MCU and the gate drivers.

During normal operation, the MCU 104 provides control signals to the gate drivers 120 to control the state of the HS drive transistors 122 and the LS drive transistors 124 in a sequence to drive the electric motor. During this operation the charging capacitor 126 may store and discharge energy to drive the electric motor. When the MCU 104 receives a command to put the inverter in a safe state, there may be a charge remaining on the charging capacitor 126. As described above, this charging capacitor 126 needs to be safely and quickly discharged to prevent injury to personnel. This may be accomplished by the MCU 104 supplying the HS PWM control signal 108 to close the HS drive transistors 122. The MCU 104 also then applies signal 112 to enable DC link discharge mode on the LS drive transistors 124 so that the LS drive transistors 124 act as resistors to discharge and dissipate the charge on the charging capacitor 126. PWM is used to control the LS drive transistors 124 in order to control the discharge rate of the charging capacitor 126 and to thereby limit the current flowing through the different phases of the inverter 100. It is noted that all three phases of the inverter 100 may be used to dissipate the charge on the charging capacitor 126. As a result the amount of current handled by each phase is reduced. Also the use of all three phases provides a redundant discharge capability that allows for the discharge to be carried out even if one of the phases fails. In alternative embodiments, fewer phases, including one phase, may be used to discharge the charging capacitor 126. Also in alternative embodiments, the HS drive transistors 122 may act as the resistors controlled by the PWM control signal 112 and the LS drive transistors 124 may be the open switches during the discharge mode.

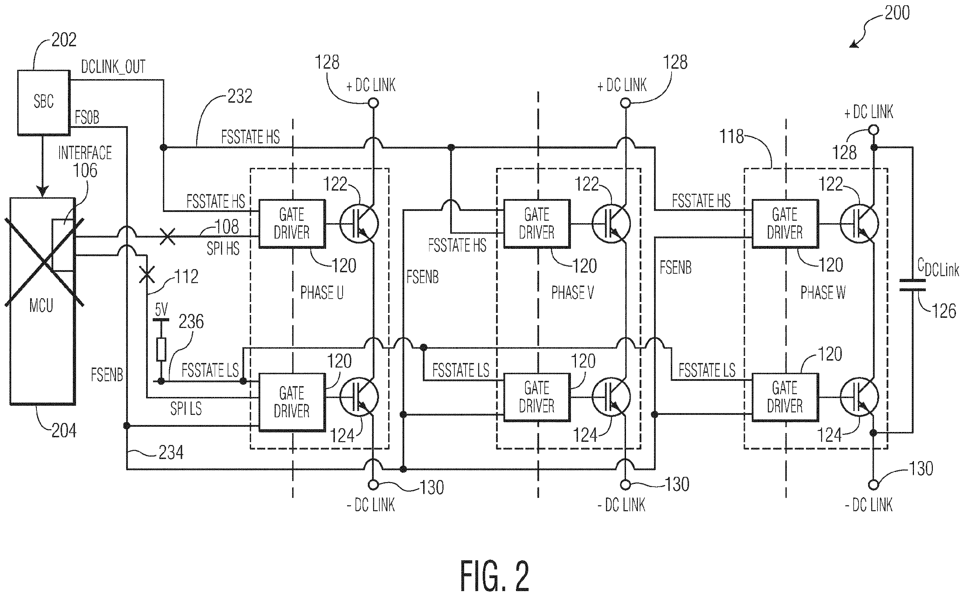

A problem with the inverter 100 of FIG. 1 is that if the MCU 104 fails, then the inverter 100 cannot carry out a safe discharge of the charging capacitor 126. FIG. 2 illustrates an embodiment of an inverter that accounts for a failure of the MCU. The inverter 200 in FIG. 2 includes the same gate drivers 120, HS drive transistors 122, and LS drive transistors 124 as the inverter 100 in FIG. 1. The inverter 200 will include a SBC 202 that includes additional functionality to provide control signals to the gate drivers 120 to perform a discharge of the charging capacitor 126. The MCU 204 may be the same as the MCU 104 or may be different in order to provide an interface to the SBC 202 to detect failures of the MCU 204.

The SBC 202 may have two outputs, DCLINK_OUT and FS0B, that output the signals FSSTATE HS control signal 232 and FSENB control signal 234 respectively. The FSSTATE HS control signal 232 is provided to the HS gate drivers 120. The FSSTATE HS control signal 232 may be used to control the operation of the HS drive transistors 122 when the MCU 204 experiences a failure. The FSENB control signal 234 is provided to the HS gate drivers 120 to indicate that HS gate drivers 120 should use the input signal FSSTATE HS control signal 232 to control the HS drive transistors 122. The FSENB control signal 234 is also provided to the LS gate drivers 120 to indicate that LS gate drivers 120 should use the input signal FSSTATE LS control signal 236 to control the LS drive transistors 124. The FSSTATE LS control signal 236 may be just kept in a state (in this example a high state) that will indicate that the LS gate drivers 120 should close the LS drive transistors 124.

Typically the SBC 202 monitors the operation of the MCU 204. This monitoring may be used to determine if the MCU 204 has failed. For example, the SBC 202 may use a watchdog signal and protocol to determine if the MCU 204 has failed. Further, the MCU 204 may output error codes indicating that the MCU 204 operation has failed in some manner. In another example, the MCU 204 may have the ability to detect the presence of the FSSTATE HS control signal 232 and FSENB control signal 234, and the MCU 204 may override these signals by sending an override signal to the gate drivers 120. Also, at the gate drivers 120, the control signals from the MCU 104 may have higher priority than the control signals from the SBC 102. Because of this functionality, the SBC 202 may occasionally send the FSSTATE HS control signal 232 and FSENB control signal 234 signals and determine if they are aborted by the MCU 204. If so then the MCU 204 is operating properly, and if not, then the MCU 204 is not operating properly.

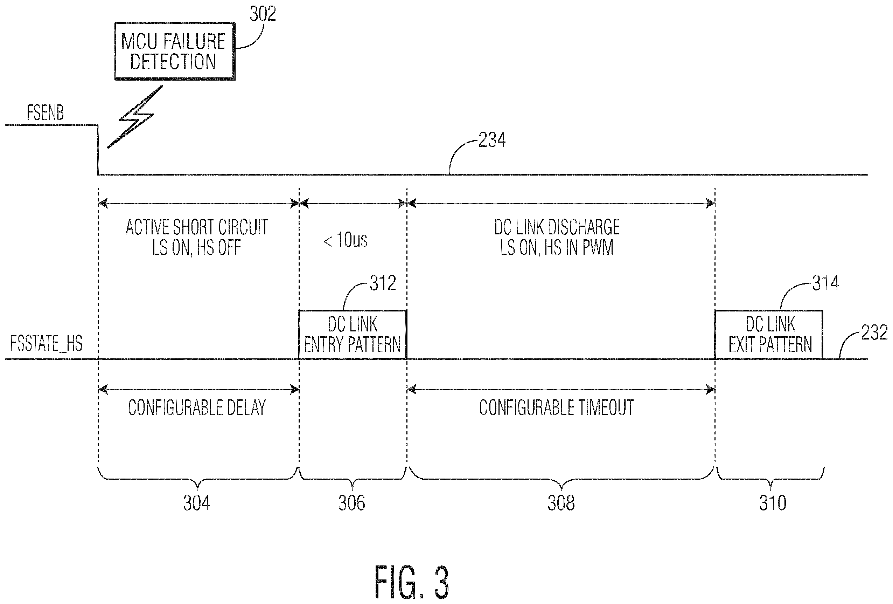

FIG. 3 illustrates the control signals for entering and exiting the discharge mode. At some time the SBC 202 detects a MCU failure 302. When the MCU 204 fails, the FSENB control signal 234 goes from high to low (it is noted that this logic may be reversed as well). Also at this time the FSSTATE HS control signal 232 remains low (it is noted that this logic may be reversed as well). As a result, the inverter 100 enters an initial delay phase 304 of operation. This initial delay phase 304 may be configurable and may be on the order of a few ms to hundreds of ms to a few seconds depending on the specific application and requirements. This initial delay may be set to allow for the electric motor driven by the inverter 100 to come to a complete stop. During the initial delay phase 304 the phases are set to be in an active short circuit by having the LS drive transistors 124 turn on and the HS drive transistors 122 turn off. Also, during this initial delay phase 302, the MCU 204 may override or abort any control signals output by the SBC 202 that will cause the inverter 100 to enter the discharge mode.

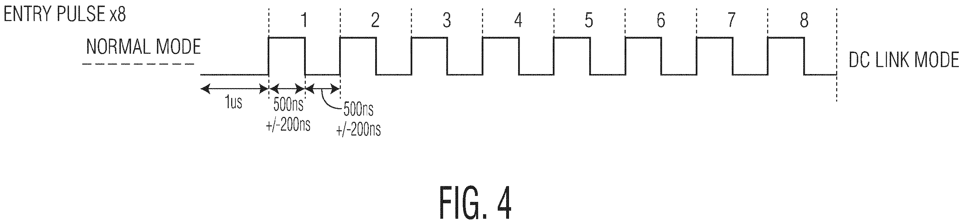

After the initial delay phase 304, the inverter 100 enters the discharge entry phase 306. During the discharge entry phase 306, THE FSSTATE HS control signal 232 transmits a DC LINK entry pattern 312. The DC LINK entry pattern 312 is a unique signal that indicates that the inverter is entering the discharge phase. The pattern is selected so that random noise or other inadvertent signals do not accidentally start the discharge phase of the inverter 100. FIG. 4 illustrates one example of a DC LINK entry pattern 312. In this case it is a series of 8 pulses with a specific timing. The duty cycle is shown as 50% with a period of 1µs. Other duty cycles, periods, number of pulses, and patterns may also be used, as long as the DC LINK entry pattern 312 is unique and resistant to random noise. Further, the pattern selection may be made based on filtering of the signal at the gate driver 120.

After the discharge entry phase 306, a discharge phase 308 begins in response to the DC LINK entry pattern 312. During the discharge phase 308, the LS drive transistors 124 are on and the HS drive transistors 122 are driven with a PWM signal to cause the charging capacitor 126 to discharge. The PWM is used to cause a controlled discharge of the charging capacitor 126 so that the amount of current flowing through the HS drive transistors 122 and the LS drive transistors 124 is controlled and limited. At this time the HS drive transistors 122 act as resistors to dissipate the energy discharged from the charging capacitor 126. Further the length of the discharge phase 308 may be configurable. The length of the discharge phase 308 may be set to meet any discharge requirements that may be placed on the inverter 100. Also the length of the discharge phase 308 is a configurable timeout that limits the length of the discharge mode.

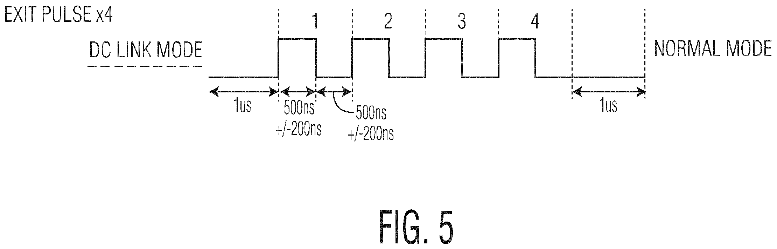

After the discharge phase 308, the inverter 100 enters the discharge exit phase 310. During the discharge exit phase 310, THE FSSTATE HS control signal 232 transmits a DC LINK exit pattern 314. The DC LINK exit pattern 314 is a unique signal that indicates that the inverter is exiting the discharge phase. The pattern is selected so that random noise or other inadvertent signals do not accidentally start the discharge phase of the inverter 100. FIG. 5 illustrates one example of a DC LINK exit pattern 314. In this case it is a series of 4 pulses with a specific timing. The duty cycle is shown as 50% with a period of 1µs. Other duty cycles, periods, number of pulses, and patterns may also be used, as long as the DC LINK exit pattern 314 is unique and resistant to random noise. Further, the pattern selection may be made based on filtering of the signal at the gate driver 120.

In the above description, the HS drive transistors 122 are driven with the PWM signal during discharge phase 308, and the LS drive transistors 124 are driven with a constant value to turn them on. In other embodiments, this may be reversed, i.e., the LS drive transistors 124 are driven with the PWM signal during discharge phase 308, and the HS drive transistors 122 are driven with a constant value to turn them on.

Further, the embodiment of FIG. 2 illustrates that all three of the phases are used to discharge the charging capacitor 126. Only two phases may be used as well to spread the current discharge out and to provide some redundancy in case of failure of one of the phases during the discharge phase. Even only one phase may be used as long as it is able to handle the maximum discharge current and the system can tolerate not having redundancy in the discharge system. Further, the inverter 100 may also have more than three phases, and then any number of these phases may be used to discharge the charging capacitor 126.

While the embodiment of FIG. 2 is described as being applied to an electric motor, it may be used in other phased systems as well.

The foregoing disclosure provides illustration and description but is not intended to be exhaustive or to limit the aspects to the precise form disclosed. Modifications and variations may be made in light of the above disclosure or may be acquired from practice of the aspects.

As used herein, the term "component" is intended to be broadly construed as hardware, firmware, and/or a combination of hardware and software. As used herein, a processor is implemented in hardware, firmware, and/or a combination of hardware and software.

As used herein, satisfying a threshold may, depending on the context, refer to a value being greater than the threshold, greater than or equal to the threshold, less than the threshold, less than or equal to the threshold, equal to the threshold, not equal to the threshold, and/or the like. It will be apparent that systems and/or methods described herein may be implemented in different forms of hardware, firmware, and/or a combination of hardware and software. The actual specialized control hardware or software code used to implement these systems and/or methods is not limiting of the aspects. Thus, the operation and behavior of the systems and/or methods were described herein without reference to specific software code-it being understood that software and hardware can be designed to implement the systems and/or methods based, at least in part, on the description herein.

As used herein, the term "non-transitory machine-readable storage medium" will be understood to exclude a transitory propagation signal but to include all forms of volatile and nonvolatile memory. When software is implemented on a processor, the combination of software and processor becomes a specific dedicated machine.

Because the data processing implementing the embodiments described herein is, for the most part, composed of electronic components and circuits known to those skilled in the art, circuit details will not be explained in any greater extent than that considered necessary as illustrated above, for the understanding and appreciation of the underlying concepts of the aspects described herein and in order not to obfuscate or distract from the teachings of the aspects described herein.

Unless stated otherwise, terms such as "first" and "second" are used to arbitrarily distinguish between the elements such terms describe. Thus, these terms are not necessarily intended to indicate temporal or other prioritization of such elements.

It should be appreciated by those skilled in the art that any block diagrams herein represent conceptual views of illustrative hardware embodying the principles of the aspects.

While each of the embodiments are described above in terms of their structural arrangements, it should be appreciated that the aspects also cover the associated methods of using the embodiments described above.

Even though particular combinations of features are recited in the claims and/or disclosed in the specification, these combinations are not intended to limit the disclosure of various aspects. In fact, many of these features may be combined in ways not specifically recited in the claims and/or disclosed in the specification. Although each dependent claim listed below may directly depend on only one claim, the disclosure of various aspects includes each dependent claim in combination with every other claim in the claim set. A phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

No element, act, or instruction used herein should be construed as critical or essential unless explicitly described as such. Also, as used herein, the articles "a" and "an" are intended to include one or more items and may be used interchangeably with "one or more." Furthermore, as used herein, the terms "set" and "group" are intended to include one or more items (e.g., related items, unrelated items, a combination of related and unrelated items, and/or the like), and may be used interchangeably with "one or more." Where only one item is intended, the phrase "only one" or similar language is used. Also, as used herein, the terms "has," "have," "having," and/or the like are intended to be open-ended terms. Further, the phrase "based on" is intended to mean "based, at least in part, on" unless explicitly stated otherwise.

## Claims

1. An inverter circuit, comprising:
a first phase circuit including:
a first transistor;
a first gate driver configured to control the first transistor;
a second transistor connected in series with the first transistor; and
a second gate driver configured to control the second transistor;
a microcontroller unit (MCU) configured to produce a first control signal and a second control signal to control an operation of the first gate driver and the second gate driver, respectively, wherein the first control signal and second control signal are configured to control a discharge of a charging capacitor connected to the first phase circuit; and
a power management circuit configured to:
detect a failure in an operation of the MCU; and
produce a third control signal and a fourth control signal to control the operation of the first gate driver and the second gate driver to control the discharge of the charging capacitor when the failure in the operation of the MCU is detected.

2. The inverter circuit of claim 1, wherein the power management circuit is configured to send the third control signal to indicate the failure of the MCU to the first gate driver and the second gate driver.

3. The inverter circuit of claim 2, wherein the second gate driver is configured to turn the second transistor on when the third control signal indicates the failure of the MCU.

4. The inverter circuit of claim 3, wherein the power management circuit is configured to send the fourth control signal with an entry pattern indicating a start of the discharge of the charging capacitor to the first gate driver.

5. The inverter circuit of claim 4, wherein the entry pattern is sent after a first delay period of time after the indication of the failure of the MCU.

6. The inverter circuit of claim 5, wherein the first delay period is configurable.

7. The inverter circuit of any one of claims 4 to 6, wherein the first gate driver is configured to drive the first transistor with a pulse width modulated signal after the first gate driver receives the fourth control signal with the entry pattern.

8. The inverter circuit of claim 7, wherein the power management circuit is configured to send the fourth control signal after a second delay time with an exit pattern indicating an end of the discharge of the charging capacitor to the first gate driver, wherein the exit pattern is different than the entry pattern.

9. The inverter circuit of claim 8, wherein the entry pattern includes a first number of pulses and the exit pattern includes a second number of pulses.

10. The inverter circuit of claim 8 or 9, wherein the second delay time is configurable.

11. The inverter circuit of any preceding claim, wherein the MCU is configured to override the third control signal and the fourth control signal when asserted by the power management circuit.

12. The inverter circuit of any preceding claim, further comprising:
a second phase circuit including:
a third transistor;
a third gate driver configured to control the third transistor;
a fourth transistor connected in series with the third transistor; and
a fourth gate driver configured to control the fourth transistor;
wherein the first control signal and the second control signal are configured to control the operation of the third gate driver and the fourth gate driver, respectively, and
wherein the third control signal and the fourth control signal are configured to control the operation of the third gate driver and the fourth gate driver to control the discharge of the charging capacitor when the failure in the operation of the MCU is detected.

13. The inverter circuit of any one of claims 1 to 11, further comprising a second phase circuit and a third phase circuit, wherein each of the first phase circuit and the third circuit comprises the same components as the first phase circuit;
wherein the MCU is configured to produce a first control signal and a second control signal to control an operation of the first gate drivers and the second gate drivers, respectively, wherein the first control signal and second control signal are configured to control a discharge of a charging capacitor connected to the first phase circuit; and
the power management circuit configured to:
detect a failure in an operation of the MCU; and
produce a third control signal and a fourth control signal to control the operation of the first gate drivers and the second gate drivers to control the discharge of the charging capacitor when the failure in the operation of the MCU is detected.

14. The inverter circuit of claim 13, wherein the power management circuit is configured to send the third control signal to indicate the failure of the MCU to the first gate drivers and the second gate drivers.

15. The inverter circuit of claim 14, wherein the second gate drivers are configured to turn the second transistors on when the third control signal indicates the failure of the MCU.

## Amended claims

### Amended claims in accordance with Rule 137(2) EPC.

1. An inverter circuit (200), comprising:
a first phase circuit (114) including:
a first transistor (122);
a first gate driver (120) configured to control the first transistor (122);
a second transistor (124) connected in series with the first transistor (122); and
a second gate driver (120) configured to control the second transistor (124);
a microcontroller unit,MCU, (204) configured to produce a first control signal (108) and a second control signal (112) to control an operation of the first gate driver (120) and the second gate driver (120), respectively, wherein the first control signal (108) and second control signal (112) are configured to control a discharge of a charging capacitor (126) connected to the first phase circuit (114); and
a power management circuit (202) configured to:
monitor an operation of the MCU (204) and to detect a failure in the operation of the MCU (204); and
produce a third control signal (232) and a fourth control signal (234) to control the operation of the first gate driver (120) and the second gate driver (120) to control the discharge of the charging capacitor (126) when the failure in the operation of the MCU (204) is detected by the power management circuit (202).

2. The inverter circuit (200) of claim 1, wherein the power management circuit (202) is configured to send the third control signal (232) to indicate the failure of the MCU (204) to the first gate driver (120) and the second gate driver (120).

3. The inverter circuit (200) of claim 2, wherein the second gate driver (120) is configured to turn the second transistor (124) on when the third control signal (232) indicates the failure of the MCU (204).

4. The inverter circuit (200) of claim 3, wherein the power management circuit (202) is configured to send the fourth control signal (234) with an entry pattern indicating a start of the discharge of the charging capacitor (126) to the first gate driver (120).

5. The inverter circuit (200) of claim 4, wherein the entry pattern is sent after a first delay period of time after the indication of the failure of the MCU (202).

6. The inverter circuit (200) of claim 5, wherein the first delay period is configurable.

7. The inverter circuit (200) of any one of claims 4 to 6, wherein the first gate driver (120) is configured to drive the first transistor (122) with a pulse width modulated signal after the first gate driver (120) receives the fourth control signal (234) with the entry pattern.

8. The inverter circuit (200) of claim 7, wherein the power management circuit (202) is configured to send the fourth control signal (234) after a second delay time with an exit pattern indicating an end of the discharge of the charging capacitor (126) to the first gate driver (120), wherein the exit pattern is different than the entry pattern.

9. The inverter circuit (200) of claim 8, wherein the entry pattern includes a first number of pulses and the exit pattern includes a second number of pulses.

10. The inverter circuit (200) of claim 8 or 9, wherein the second delay time is configurable.

11. The inverter circuit (200) of any preceding claim, wherein the MCU (202) is configured to override the third control signal (232) and the fourth control signal (234) when asserted by the power management circuit.

12. The inverter circuit (200) of any preceding claim, further comprising:
a second phase circuit (116) including:
a third transistor (122);
a third gate driver (120) configured to control the third transistor (122);
a fourth transistor (124) connected in series with the third transistor (122); and
a fourth gate driver (120) configured to control the fourth transistor (124);
wherein the first control signal and the second control signal are configured to control the operation of the third gate driver (120) and the fourth gate driver (120), respectively, and
wherein the third control signal (232) and the fourth control signal (234) are configured to control the operation of the third gate driver (120) and the fourth gate driver (120) to control the discharge of the charging capacitor (126) when the failure in the operation of the MCU (204) is detected.

13. The inverter circuit (200) of any one of claims 1 to 11, further comprising a second phase circuit (116) and a third phase circuit (118), wherein each of the second phase circuit (116) and the third phase circuit (118) comprises the same components as the first phase circuit (114);
wherein the MCU (204) is configured to produce a first control signal (108) and a second control signal (112) to control an operation of the first gate drivers (120) and the second gate drivers (120), respectively, wherein the first control signal (108) and second control signal (112) are configured to control a discharge of the charging capacitor (126) connected to the first phase circuit (114); and
the power management circuit (202) configured to:
detect a failure in an operation of the MCU (204); and
produce a third control signal (108) and a fourth control signal (112) to control the operation of the first gate drivers (120) and the second gate drivers (120) to control the discharge of the charging capacitor (126) when the failure in the operation of the MCU (204) is detected.

14. The inverter circuit (200) of claim 13, wherein the power management circuit (202) is configured to send the third control signal (232) to indicate the failure of the MCU (204) to the first gate drivers (120) and the second gate drivers (120).

15. The inverter circuit (200) of claim 14, wherein the second gate drivers (120) are configured to turn the second transistors (124) on when the third control signal (232) indicates the failure of the MCU (204).
